# EUROPEAN PATENT SPECIFICATION

(11) **EP 2 610 628 B1**
(45) Date of publication and mention of the grant of the patent: **16.05.2018**
(21) Application number: 11306818.3
(22) Date of filing: 30.12.2011
(51) Int. Cl.: G01R 29/08

(54) **Measuring an electromagnetic field**
Messung eines elektromagnetischen Feldes
Mesure d'un champ électromagnétique

(43) Date of publication of application: 03.07.2013
(73) Proprietor: Art-Fi, 91400 Orsay (FR)
(72) Inventor: Derat, Benoît, 92120 MEUDON (FR); Pannetrat, Stéphane, 78530 BUC (FR); Cozza, Andrea, 75014 PARIS (FR)
(74) Representative: den Braber, Gerard Paul

(56) References cited:
- EP-A1- 1 615 041
- FR-A1- 2 851 823
- JP-A- 2005 083 793
- JP-A- 2008 082 945
- JP-A- 2011 080 877

## Description

### FIELD OF THE INVENTION

An aspect of the invention relates to a system for measuring an electromagnetic field, in particular in near-field conditions. The system may be used, for example, to determine a specific absorption rate (SAR). Other aspects of the invention relate to a method of measuring an electromagnetic field, and a computer program that enables a processor to carry out such a method.

### BACKGROUND OF THE INVENTION

An electromagnetic field can be characterized in three dimensions on the basis of a two-dimensional electromagnetic field measurement. A two-dimensional electromagnetic field measurement can be achieved by means of an antenna arrangement that provides respective signals representative of the electromagnetic field at respective locations on a surface. The surface on which the electromagnetic field is measured may be referred to as measurement surface. The international patent application published under number WO 2011/080332 describes an antenna arrangement for a two-dimensional electromagnetic field measurement. Other art is known from EP1615041. In order to characterize an electromagnetic field in three dimensions, the two-dimensional electromagnetic field measurement should provide amplitude as well as phase information. This implies that some form of phase reference should be available. A phase of a signal, which is representative of the electromagnetic field at a location, can only be determined with respect to another signal that provides a phase reference. In numerous cases, the electromagnetic field to be characterized is radiated from an antenna that receives a radiofrequency power signal. In principle, this radiofrequency power signal can provide a phase reference.

However, a problem may arise in case the electromagnetic field to be characterized is radiated from a self-contained wireless device, such as, for example, a cellular phone. A self-contained wireless device typically has a casing that contains all electronic circuits, including an antenna and a radiofrequency power circuit that is coupled to the antenna. In such a case, modifications are necessary to use a radiofrequency power signal, which is applied to the antenna, as a phase reference. These modifications include at least partially opening the casing of the self-contained wireless device and providing a measurement cable between the antenna within this device and a measurement arrangement.

The self-contained wireless device that has undergone these modifications will radiate an electromagnetic field that is different from the electromagnetic field that the self-contained wireless device radiates in typical use conditions, without these modifications. Such an alteration of the electromagnetic field to be characterized is particularly undesirable in case of a specific absorption rate (SAR) measurement. In such applications, the electromagnetic field that is characterized by means of measurement should precisely reflect the electromagnetic field that a device under test radiates in typical use conditions.

### SUMMARY OF THE INVENTION

There is a need for a practical solution that allows measuring an electromagnetic field in a relatively fast and precise way, in particular in near field conditions.

In order to better address this need, and in accordance with an aspect of the invention, a system for measuring an electromagnetic field comprises:
- an antenna arrangement adapted to provide respective signals representative of the electromagnetic field at various respective locations on a measurement surface; and
- a measurement arrangement adapted to measure respective phase differences between, on the one hand, respective signals representative of the electromagnetic field at various respective locations on the measurement surface and, on the other hand, a phase reference signal representative of the electromagnetic field at a particular location on the measurement surface, whereby the particular location for which the phase reference signal is representative of the electromagnetic field remains substantially fixed for the respective phase differences that are measured.

Accordingly, a local phase reference is used, which is taken from a particular location on the measurement surface. The local phase reference is the signal that the antenna arrangement provides for this particular location in response to the electromagnetic field. In principle, the particular location that provides the local phase reference may be any location on the measurement surface. It has been found that, for the purpose of obtaining phase information, the local phase reference can be an appropriate substitute for a radiofrequency power signal that is applied to an antenna. Accordingly, there is no need to make any modifications to a device under test in order to measure an electromagnetic field that this device radiates under typical use conditions. The electromagnetic field can thus be measured in a relatively precise way.

Another aspect of the invention concerns a method of measuring an electromagnetic field, which involves an antenna arrangement adapted to produce respective signals representative of the electromagnetic field at various respective locations on a measurement surface. The method comprises a measurement cycle in which respective phase differences are measured between, on the one hand, respective signals representative of the electromagnetic field at various respective locations on the measurement surface and, on the other hand, a phase reference signal representative of the electromagnetic field at a particular location on the measurement surface, whereby the particular location for which the phase reference signal is representative of the electromagnetic field remains substantially fixed for the respective phase differences that are measured.

Yet another aspect of the invention concerns a computer program comprising a set of instructions that enables a device, which is capable of executing the set of instructions, to carry out the method according as defined hereinbefore.

An embodiment of the invention advantageously comprises one or more of the following additional features, which are described in separate paragraphs. These additional features each contribute to measuring an electromagnetic field in a relatively fast and precise way.

The measurement arrangement may advantageously derive the phase reference signal from a signal having the highest amplitude among the respective signals provided by the antenna arrangement.

The measurement arrangement may advantageously derive the phase reference signal from a signal produced by the antenna arrangement at a substantially central location on the measurement surface.

The measurement arrangement may advantageously derive the phase reference signal from various signals representative of the electromagnetic field at various neighboring locations on the measurement surface.

The measurement arrangement may advantageously discard a phase difference between a signal representative of the electromagnetic field at a location on the measurement surface and the phase reference signal in case the signal representative of the electromagnetic field at the location concerned has an amplitude that is below a threshold level.

The antenna arrangement comprises an antenna substrate provided with respective antenna devices at various respective locations on the antenna substrate, an antenna device producing a signal representative of the electromagnetic field.

The antenna arrangement may advantageously comprise a signal transmission substrate orthogonally arranged with respect to the antenna substrate, the signal transmission substrate comprising a plurality of transmission lines for transmitting an array of signals produced by an array of antenna devices towards the measurement arrangement.

The measurement arrangement may advantageously comprise:
- a selection module adapted to select a signal among the respective signals provided by the antenna arrangement;
- a pair of signal processing paths, one of which is adapted to provide a measurement input signal in response to the signal selected by the selection module, the other signal processing path being adapted to provide another measurement input signal in response to the phase reference signal; and
- a phase measurement module adapted to measure a phase difference between the one and the other measurement input signal.

The pair of signal processing paths may advantageously provide the one and the other measurement input signal as quadrature signals having a pair of components that are orthogonal to each other, whereby the phase measurement module measures an instantaneous phase from the pair of components of the measurement input signal, and measures another instantaneous phase from the pair of components of the other measurement input signal, and whereby the phase measurement module determines the phase difference on the basis of a difference between the one and the other instantaneous phase.

The phase measurement module may advantageously measure the phase difference on the basis of a time series of differences between the one and the other instantaneous phase detected at a series of instants.

The phase measurement module may advantageously comprise:
- a pair of Fourier transform modules of which one is adapted to provide a spectral representation of the measurement input signal, the other Fourier transform module being adapted to provide a spectral representation of the other measurement input signal; and
- a spectral phase comparison module adapted to determine the phase difference between the one and the other phase measurement input signal on the basis of the two spectral representations respectively provided by the one and the other Fourier transform module.

The phase measurement module may advantageously comprise a spectral analysis module that identifies, in the spectral representation of the measurement input signal, a frequency band where amplitudes are relatively high. The spectral phase comparison module may then advantageously determine the phase difference between one and the other phase measurement input signal by comparing two phase indications in the aforementioned frequency band, one phase indication being present in the spectral representation of the measurement input signal, the other phase indication being present in the spectral representation of the other measurement input signal.

The system may advantageously comprise an electromagnetic field reconstitution module being adapted to establish a three-dimensional representation of the electromagnetic field on the basis of the electromagnetic field measured in amplitude and phase on the measurement surface.

For the purpose of illustration of the invention summarized hereinbefore, as well as the additional features, a detailed description of particular embodiments is provided with reference to drawings.

### BRIEF DESCRIPTION OF THE DRAWINGS

FIG. 1 is a block diagram illustrating a system for measuring an electromagnetic field.
FIG. 2 is a flow chart diagram that illustrates a method of measuring the electromagnetic field by means of the system illustrated in FIG. 1.
FIG. 3 is a schematic diagram illustrating a perspective view of an antenna arrangement that forms part of the system illustrated in FIG. 1.
FIG. 4 is a block diagram that illustrates a phase measurement module that forms part of the system illustrated in FIG. 1.
FIG. 5 is a block diagram that illustrates an alternative phase measurement module.

### DETAILED DESCRIPTION

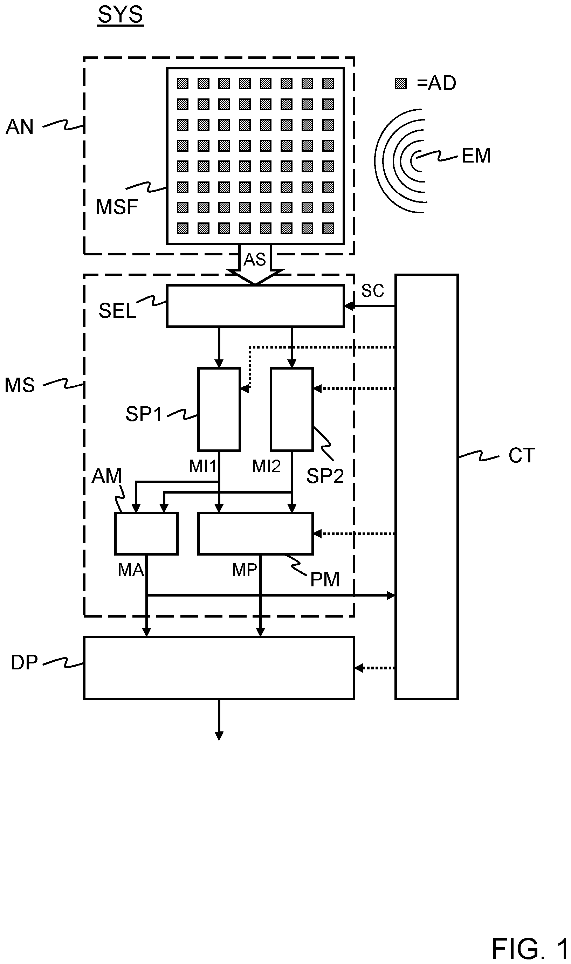

FIG. 1 schematically illustrates a system SYS for measuring an electromagnetic field EM. The system SYS comprises an antenna arrangement AN, a measurement arrangement MS, a data processing arrangement DP, and a controller CT. The antenna arrangement AN may comprise respective antenna devices AD disposed at respective locations on a surface. This surface will be referred to as measurement surface MSF hereinafter. The measurement arrangement MS may comprise a selection module SEL, a pair of signal processing paths SP1, SP2, an amplitude measurement module AM, and a phase measurement module PM. The pair of signal processing paths SP1, SP2 may comprise a first signal processing path SP1 and a second signal processing path SP2 that are substantially identical. The data processing arrangement DP may form part of a suitably programmed processor. The same applies to the controller CT, which may form part of the same suitably programmed processor.

The system SYS basically operates as follows. The antenna arrangement AN provides respective signals AS representative of the electromagnetic field EM at the respective locations on the measurement surface MSF. That is, an antenna device AD, which is disposed at a particular location on the measurement surface MSF, provides a signal that is representative of the electromagnetic field EM at this particular location. The signal that the antenna device AD provides may comprise several components, each of which may be regarded as a signal in itself. For example, the antenna device AD may provide a pair of signal components that are orthogonal to each other. Such a pair of signal components may be representative of components of the electromagnetic field EM that are orthogonal to each other. One signal component may represent a "horizontal" component of the electromagnetic field EM, the other signal component representing a "vertical component" of the electromagnetic field EM.

The selection module SEL can select two signals from all the respective signals that the antenna arrangement AN provides. In that case, the first signal processing path SP1 receives one of these two signals, and the second signal processing path SP2 receives the other signal. The selection module SEL can also select a single signal only. In that case, either the first signal processing path SP1 or the second signal processing path SP2 may receive this signal. The controller CT provides a selection control signal SC that determines the two signals that are selected, or the single signal that is selected, as the case may be.

In response to a selected signal from the antenna arrangement, the first signal processing path SP1 provides an output signal that will be designated as first measurement input signal MI1hereinafter. The second signal processing path SP2 provides an output signal that will be designated as second measurement input signal MI2 hereinafter. In case two signals from the antenna arrangement AN are selected, the pair of signal processing paths SP1, SP2 thus provides a pair of measurement input signals MI1, MI2.

In more detail, the first signal processing path SP1 and the second signal processing path SP2 may each carry out a similar series of signal processing operations. This series of signal processing operations may include a frequency conversion so as to frequency shift a signal that an antenna device AD provides. Accordingly, a frequency shifted antenna signal is obtained, which may be subjected to a filter so as to effectively select a spectral portion of the antenna signal concerned. The frequency conversion may be carried out by means of a local oscillator, which the pair of signal processing paths SP1, SP2 may share. Other signal processing operations may include amplification, a frequency control of the local oscillator, and analog to digital conversion. The pair of measurement input signals MI1, MI2 may thus be in a digital form, whereby a measurement input signal constitutes a stream of digital signal samples.

The phase measurement module PM can measure a phase difference between the pair of measurement input signals MI1, MI2, if such a pair is present. In any event, the amplitude measurement module AM can measure an amplitude of the first measurement input signal MI1, and can also measure an amplitude of the second measurement input signal MI2. The phase difference and the amplitude that have been measured accordingly will be referred to hereinafter as measured phase difference MP and measured amplitude MA, respectively.

The data processing arrangement DP receives the measured phase difference MP and the measured amplitude MA that the measurement arrangement MS provides. The data processing arrangement DP can establish a two-dimensional characterization of the electromagnetic field EM on the basis of respective measured phase differences MP and measured amplitudes MA, which have been measured for respective locations on the measurement surface MSF. The data processing arrangement DP can further establish a three-dimensional representation of the electromagnetic field EM on the basis of the aforementioned two-dimensional characterization. The controller CT may also receive the measured amplitude MA for purposes that will be described hereinafter.

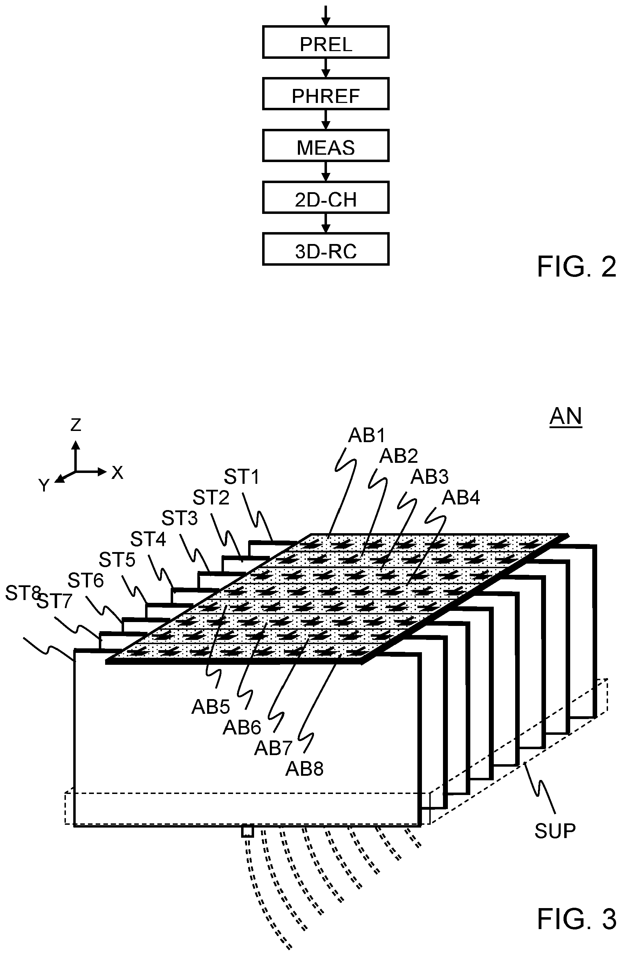

FIG. 2 illustrates a method of measuring an electromagnetic field EM by means of the system SYS illustrated in FIG. 1. The method comprises a series of steps, which the system SYS illustrated in FIG. 1 carries out under the control of the controller CT. FIG. 2 may be regarded as a flowchart representation of a set of instructions, that is, software, which enables the system SYS to carry out various operations described hereinafter with reference to FIG. 2. More specifically, the controller CT of the system SYS illustrated in FIG. 1 may carry out these operations by executing the set of instructions, which is stored in a memory. In general, the set of instructions may be comprised in a device readable medium, which may be in the form of, for example, a data carrier. The device readable medium comprising the set of instructions may be commercialized in association with the system SYS illustrated in FIG. 1, or a similar system.

In a preliminary step PREL, the controller CT causes the selection module SEL to successively select respective signals AS from respective antenna devices AD disposed on the measurement surface MSF. That is, the controller CT causes the selection module SEL to successively select the respective antenna devices AD, one by one, so that a signal from a momentarily selected antenna device AD is applied to one of the two signal processing path SP1, SP2. Accordingly, the amplitude measurement module AM receives a series of successive measurement input signals, each of which is uniquely associated with a specific antenna device AD on the measurement surface MSF. As a result, the amplitude measurement module AM provides a measured amplitude MA for each one of the respective antenna devices AD that are successively selected. The preliminary step PREL may thus be regarded as an amplitude scan of the measurement surface MSF, which provides a measured amplitude distribution over this surface.

In a phase reference definition step PHREF, the controller CT defines a phase reference signal, which may be a particular signal among the respective signals that the respective antenna devices AD provide. For example, the controller CT may identify a signal that has the highest amplitude MA among the respective signals that are successively selected in the preliminary step PREL. The controller CT may then define that this signal constitutes the phase reference signal in a two-dimensional electromagnetic field measurement, which will be described in greater detail hereinafter. As another example, the controller CT may define that a signal from an antenna device AD that has a central location on the measurement surface MSF constitutes the phase reference signal.

In the latter example, the controller CT may advantageously check whether a signal from a centrally located antenna device AD has a measured amplitude MA that exceeds a particular threshold, which will be referred to as phase reference selection threshold hereinafter. In case the signal does not exceed the phase reference selection threshold, the controller CT may carry out similar checks on signals from neighboring antenna devices AD, which are also substantially centrally located, so as to identify a signal having a measured amplitude MA that does exceed the phase reference selection threshold. The controller CT can then define that this signal constitutes the phase reference signal.

As yet another example, the controller CT may evaluate respective measured amplitudes MA for respective antenna devices AD that form a cluster having a central location on the measurement surface MSF. This evaluation allows the controller CT to determine a signal from this centrally located cluster of the antenna devices AD that has the highest amplitude MA. The controller CT may then define this signal, which has the highest amplitude MA in the cluster, as the phase reference signal for the two-dimensional electromagnetic field measurement, which will be described in greater detail hereinafter.

The phase reference signal may also be a combination of various respective signals from various respective antenna devices AD that form a cluster. In that case, the phase reference signal is derived from various signals representative of the electromagnetic field EM at various neighboring locations on the measurement surface MSF. The cluster of respective antenna devices AD, which provide the signals from which the phase reference signal is derived, may advantageously be centrally located. A signal that does not exceed the phase reference selection threshold may be eliminated from the cluster, so that this signal does not contribute to the phase reference signal.

The phase reference selection threshold may be defined in various different manners. For example, the phase reference selection threshold may be a predetermined fixed value. As another example, the phase reference selection threshold may be determined on the basis of the respective measured amplitudes MA in the preliminary step PREL. The selection threshold may be based on an average value, or a median value.

In a measurement step MEAS, the controller CT causes the selection module SEL to again successively select respective signals AS from respective antenna devices AD disposed on the measurement surface MSF. That is, the controller CT again causes the selection module SEL to successively select the respective antenna devices AD, one by one, so that a signal from a momentarily selected antenna device AD is applied to one of the two signal processing path SP1, SP2. This operation is similar to that in the preliminary step PREL. However, in the measurement step MEAS, the controller CT further causes the selection module SEL to apply the phase reference signal to the other one of the two signal processing paths SP1, SP2. This applies throughout the measurement step MEAS.

The measurement arrangement MS may operate in a multiplex mode. In this mode, respective signals from respective momentarily selected antenna devices AD are alternately applied to the first signal processing path SP1 and to the second signal processing path SP2. In a complementary fashion, the phase reference signal is alternately applied to the first signal processing path SP1 and to the second signal processing path SP2. For example, let it be assumed that a signal from a given momentarily selected antenna device is applied to the first signal processing path SP1 and that the phase reference signal is applied to the second signal processing path SP2. A signal from a subsequently momentarily selected antenna device will then be applied to the second signal processing path SP2 and the phase reference signal will be applied to the first signal processing path SP1.

Accordingly, in the measurement step MEAS, the phase measurement module PM receives a series of successive pairs of measurement input signals MI1, MI2. In a pair of measurement input signals MI1, MI2, one measurement input signal is associated with an antenna device AD that is currently selected. The other measurement input signal is a processed version of the phase reference signal. This applies to each of the pairs of measurement signals that the phase measurement module PM receives. As a result, the phase measurement module PM provides a measured phase difference MP with respect to the phase reference signal for each one of the antenna devices AD that are successively selected in the measurement step MEAS. In parallel, the amplitude measurement module AM provides a measured amplitude MA for each one of these successively selected antenna devices AD. The measurement step MEAS may thus be regarded as an amplitude and phase scan of the measurement surface MSF, which provides a measured amplitude distribution and a measured phase distribution over this surface.

The measurement step may optionally be followed by a measurement verification step in which the data processing arrangement DP compares the measured amplitude distribution that has been obtained in the measurement step MEAS with the measured amplitude distribution that has been obtained in the preliminary step PREL. Accordingly, an amplitude distribution difference is obtained, which may be expressed by means of one or more statistical metrics. The amplitude distribution difference may be significant if, for example, a device under test is unstable, if the device under test switches relatively rapidly between different modes of operation, or if the device under test is moving relatively fast with respect to the antenna arrangement AN. The data processing arrangement DP may provide an indication to an operator of the system SYS regarding the amplitude difference distribution. Such an indication may inform the operator of a potential lack of measurement reliability. For example, the data processing arrangement DP may generate a reliability warning if the amplitude distribution difference exceeds a verification threshold.

In a two-dimensional characterization step 2D-CH, the data processing arrangement DP stores, at least temporarily, respective measured amplitudes MA and respective measured phase differences MP that the amplitude measurement module AM and the phase measurement module PM, respectively, provide. The data processing arrangement DP may then establish a two-dimensional characterization of the electromagnetic field EM on the basis of these stored measurement results. In this respect, respective antenna devices AD on the measurement surface MSF may be regarded as respective sampling points for the electromagnetic field EM, which is measured in amplitude and phase on the measurement surface MSF. The two-dimensional characterization of the electromagnetic field EM may involve applying calibration coefficients to the respective measured amplitudes MA and the respective measured phase differences MP. Such calibration coefficients express a conversion of measured signal values into electromagnetic field parameter values.

In establishing the two-dimensional characterization of the electromagnetic field EM, the data processing arrangement DP may discard a measurement result, which is associated with an antenna device AD. The data processing arrangement DP may discard a measurement result if the measured amplitude MA for the antenna device AD concerned is below a measurement threshold. That is, the data processing arrangement DP discards a measurement result if the measurement result has a signal-to-noise ratio that is below a critical level. This contributes to a relatively reliable characterization of the electromagnetic field EM because relatively unreliable measurement results are not taken into account. The measurement threshold may be defined in various different manners. The remarks made hereinbefore with regard to the phase reference selection threshold also apply to the measurement threshold.

In a general way, the data processing arrangement DP can reconstruct the electromagnetic field EM at non-measured locations, for example, at locations outside the measurement surface MSF. This is possible thanks to the fact that the measurement results, which the measurement arrangement MS provides, convey amplitude information and phase information for various locations on the measurement surface MSF.

In a three-dimensional reconstruction step 3D-RC, the data processing arrangement DP establishes a three-dimensional representation of the electromagnetic field EM in a given volume on the basis of the measurement results, which the measurement arrangement MS has provided. The measurement results characterize the electromagnetic field EM in two dimensions: a horizontal dimension "X" and in a vertical dimension "Y" that lie on the measurement surface MSF. In effect, the data processing arrangement DP is capable of adding an additional dimension "Z" that is orthogonal with respect to the measurement surface MSF. For example, the data processing arrangement DP can apply Maxwell's equations so as to determine a third component "Z" of the electromagnetic field EM at a location on the measurement surface MSF.

The data processing arrangement DP may use, for example, transformations of the FFT type in order to establish a three-dimensional representation of the electromagnetic field EM in a given volume (FFT is an acronym for Fast Fourier transform). In accordance with a particular implementation, the data processing arrangement DP applies an FFT transformation to a data matrix that constitutes the two-dimensional spatial characterization of the electromagnetic field EM on the measurement surface MSF. This FFT transformation produces an equivalent spectral representation. The data processing arrangement DP can then apply a propagation operator in the "Z" dimension to the equivalent spectral representation. This produces a spectral representation of the electromagnetic field EM at a surface that is shifted with respect to the measurement surface MSF in the "Z" dimension. The data processing arrangement DP applies an IFFT transformation to this last mentioned spectral representation; the IFFT transformation being opposite to the FFT transformation. A data matrix is thereby obtained, which constitutes a two-dimensional spatial representation of the electromagnetic field EM at this Z-shifted surface. The data processing arrangement DP may thus determine respective spatial representations of the electromagnetic field EM for respective surfaces, which are differently shifted with respect to the measurement surface MSF. By doing so, the data processing arrangement DP can produce the three-dimensional representation of the electromagnetic field EM in a relatively short time.

FIG. 3 schematically illustrates by means of a perspective view an implementation of the antenna arrangement AN, which forms part of the system SYS described hereinbefore with reference to FIG. 1. This implementation will directly be referred to as the antenna arrangement AN hereinafter for reasons of convenience. The antenna arrangement AN comprises several antenna bars AB 1-AB8 and several signal transmission boards ST1-ST8. An antenna bar AB* is coupled to a signal transmission board ST * (the sign * represents any number ranging between 1 and 8). An antenna bar AB* constitutes a plane on which an array of antenna devices AD is disposed. The antenna bars AB 1-AB8 may each be in the form of, for example, a printed circuit in which the antenna devices AD have been formed by means of etching. The printed circuit may be, for example, on a FR-4 type of substrate. The signal transmission boards ST1-ST8 may comprise a similar type of substrate.

A signal transmission board ST * is orthogonally disposed with respect to an antenna bar AB*. That is, the signal transmission board ST *is orthogonally disposed with respect to the plane on which the array of antenna devices AD is disposed. A signal transmission board ST* comprises several transmission lines: typically a transmission line for each antenna device AD present on the antenna bar. A transmission line transmits a pair of signals coming from the antenna device AD to which it belongs, in the direction of the measurement arrangement MS.

The antenna arrangement AN may comprise a support SUP for mechanically fixing the signal transmission boards ST1-ST8 and the antenna bars AB1-AB8 coupled thereto. A system SYS of axes "X", "Y", and "Z" is indicated in FIG. 3 by means of three arrows, each one representing a particular axis. These axes "X", "Y", and "Z" correspond to the dimensions "X", "Y", and "Z", respectively, mentioned hereinbefore. It should be noted that the antenna bars AB 1-AB8 may geometrically be disposed in various different ways. For reasons of simplicity, FIG. 3 illustrates a basic arrangement in which the antenna bars AB 1-AB8 form a flat surface. However, the antenna bars AB 1-AB8 may be disposed differently so that these form, for example, a curved surface. In order to do so, some antenna bars may be shifted along axis "Z". The support SUP illustrated in FIG. 3 may be designed to provide such a shift. In an alternative way, it is also possible to provide for signal transmission boards of different heights; a particular height corresponding to a particular distance along the axis "Z".

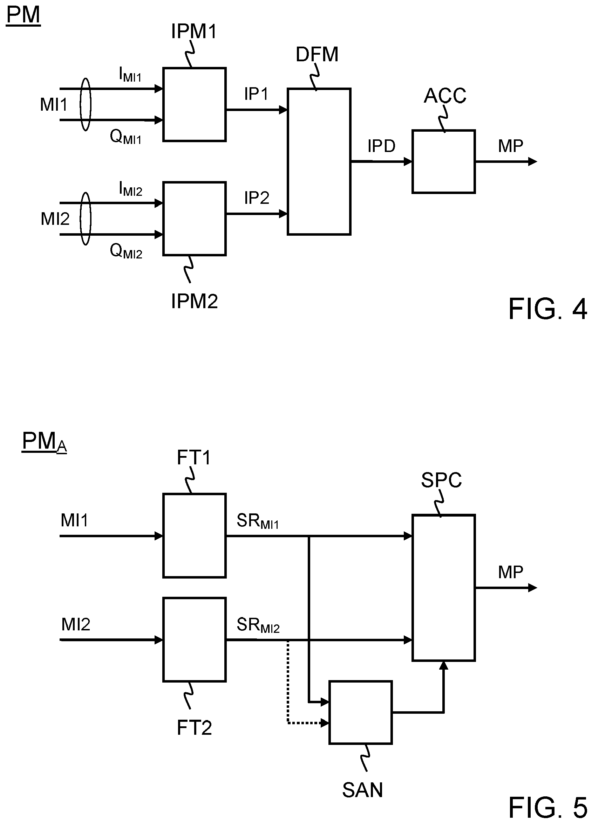

FIG. 4 schematically illustrates an implementation of the phase measurement module PM that forms part of the system SYS illustrated in FIG. 1. This implementation will directly be referred to as the phase measurement module PM hereinafter for reasons of convenience. The phase measurement module PM comprises a pair of instantaneous phase measurement sections IPM1, IPM2: a first instantaneous phase measurement section IPM1 and a second instantaneous phase measurement section IPM2. The phase measurement module PM further comprises a difference measurement section DFM and an accumulation section ACC.

The phase measurement module PM illustrated in FIG. 4 basically operates as follows. The phase measurement module PM receives the pair of measurement input signals MI1, MI2 as quadrature signals, each measurement input signal having a pair of components that are orthogonal to each other. This implies that the pair of signal processing paths SP1, SP2 is arranged to provide such quadrature signals. The first instantaneous phase measurement section IPM1 measures a first instantaneous phase IP1 from the pair of components of the first measurement input signal MI1. The first instantaneous phase IP1 is a phase that the first measurement input signal MI1 has at a specific instant, which constitutes a sampling point in time. Similarly, the second instantaneous phase measurement section IPM2 measures a second instantaneous phase IP2 from the pair of components of the second measurement input signal MI2. The second instantaneous phase IP2 is measured at the same specific instant. The sampling point in time is thus the same. The difference measurement section DFM measures a difference between the first instantaneous phase IP1 and the second instantaneous phase IP2. This difference will be referred to as instantaneous phase difference IPD hereinafter.

The phase measurement module PM illustrated in FIG. 4 may provide a time series of respective instantaneous phase differences IPD for an antenna device AD that is currently selected. These respective instantaneous phase differences IPD have been measured at respective different instants. That is, the respective instantaneous phase differences IPD relate to respective sampling points in time.

The accumulation section ACC can establish a phase difference MP for a currently selected antenna device AD on the basis of a time series of respective instantaneous phase differences IPD. This phase difference may then constitute the measured phase difference MP mentioned hereinbefore with reference to FIG. 2. For example, the accumulation section ACC may apply an averaging operation to the time series of respective instantaneous phase differences IPD.

FIG. 5 schematically illustrates an alternative implementation of the phase measurement module PM. This implementation will be referred to as the alternative phase measurement module PM_{A} hereinafter for reasons of convenience. The alternative phase measurement module PM_{A} comprises a pair of Fourier transform sections FT1, FT2: a first Fourier transform section FT1 and a second Fourier transform section FT2. The alternative phase measurement module PM_{A} further comprises a spectral analysis section SAN and a spectral phase comparison section SPC.

The alternative phase measurement module PM_{A} basically operates as follows. The first Fourier transform section FT1 provides a spectral representation SR_{MI1} of the first measurement input signal MI1. For the sake of explanation, it is assumed that the first measurement input signal MI1 is processed version of a signal from a currently selected antenna device AD. The second Fourier transform section FT2 provides a spectral representation SR_{MI2} of the second measurement input signal MI2. For the sake of explanation, it is assumed that the second measurement input signal MI2 is a processed version of the phase reference signal.

The spectral analysis section SAN analyzes the spectral representation SR_{MI1} of the first measurement input signal MI1 so as to identify a frequency band where amplitudes are relatively high. A phase measurement will focus, as it were, on this high-amplitude frequency band as will be explained in greater detail hereinafter. This frequency selective focus can contribute to a reliable phase measurement.

The spectral phase comparison section SPC compares two phase indications in the high-amplitude frequency band. One phase indication is present in the first spectral representation SR_{MI1} of the first measurement input signal MI1, which is derived from a currently selected antenna device AD. The other phase indication is present in the spectral representation SR_{MI2} of the second measurement input signal MI2, which is derived from the phase reference signal. The spectral phase comparison section SPC can determine the measured phase difference MP for the currently selected antenna device AD by comparing the two aforementioned phase indications.

### FINAL REMARKS

The detailed description hereinbefore with reference to the drawings is merely an illustration of the invention and the additional features, which are defined in the claims. The invention can be implemented in numerous different ways. In order to illustrate this, some alternatives are briefly indicated.

The invention may be applied to advantage in numerous types of products or methods related to measuring an electromagnetic field. Determining a specific absorption rate for a device under test is merely an example. In general, the invention may be applied to advantage for measuring an electromagnetic field that is radiated by a self-contained device under test.

There are numerous ways of measuring an electromagnetic field in accordance with the invention. Such a measurement may be different from that described hereinbefore with reference to FIG. 2. For example, the preliminary step PREL may be omitted. In such a variant, the phase reference signal is then defined without amplitude measurements that have preliminary been carried out. A predefined antenna device, or a predefined cluster of antenna devices, may then provide the phase reference signal. A single amplitude measurement may optionally be carried out in order to verify whether the phase reference signal has a sufficiently high amplitude, or not.

An electromagnetic field measurement may comprise several measurement steps, which are successively carried out. Each measurement step then provides a measured amplitude distribution and a measured phase distribution over a measurement surface. Two respective measured amplitude distributions obtained in two respective measurement steps may then be compared with each other in a fashion as described hereinbefore with regard to the measurement verification step. Accordingly, a measurement reliability indication can be obtained. It should further be noted that a phase reference definition step may be carried out between two successive measurements steps. The measured amplitude distribution obtained in the measurement step that is firstly carried out may then serve as a basis for defining a phase reference signal for the measurement step that follows.

It should further be noted that the system illustrated in FIG. 1 may operate in a non-multiplex mode. That is, a signal from a momentarily selected antenna device AD may systematically be applied to the first signal processing path SP1, or to the second signal processing path SP2. The phase reference signal may then systematically be applied to the second signal processing path SP2, or the first signal processing path SP1, respectively.

There are numerous ways of implementing an antenna arrangement in accordance with the invention. Such an implementation may be different from that described with reference to FIG. 3. For example, in an alternative implementation, the antenna arrangement may comprise a fixed antenna device, which provides a phase reference signal, and a single movable antenna device, which may be attached to a controllable arm. In a measurement step, the single movable antenna device is placed at various different locations on a measurement surface. At each different location, the single movable antenna device provides a signal representative of the electromagnetic field at this location.

There are numerous ways of implementing a measurement arrangement in accordance with the invention. Such an implementation may be different from those described hereinbefore with reference to FIGS. 4 and 5. For example, referring to FIG. 4, the accumulation section ACC may be omitted. In such a variant, a phase difference is directly derived from a single instantaneous phase difference measurement. As another example, referring to FIG. 5, the spectral analysis section SAN may be omitted. In such a variant, a phase difference is derived by comparison of two spectra in their entirety, as provided by the pair of Fourier transform sections FT1, FT2.

In general, there are numerous different ways of implementing the invention, whereby different implementations may have different topologies. In any given topology, a single module may carry out several functions, or several modules may jointly carry out a single function. In this respect, the drawings are very diagrammatic. For example, referring to FIGS. 1 and 3, a portion of the selection module SEL may be provided on the signal transmission boards ST1-ST8. As another example, the amplitude measurement module AM, the phase measurement module PM, and data processing arrangement DP may form part of a single processor circuit. The same applies to other functional entities and modules that have been described.

There are numerous functions that may be implemented by means of hardware or software, or a combination of both. A description of a software-based implementation does not exclude a hardware-based implementation, and vice versa. Hybrid implementations, which comprise one or more dedicated circuits as well as one or more suitably programmed processors, are also possible. For example, various functions described hereinbefore with reference to the figures may be implemented by means of one or more dedicated circuits, whereby a particular circuit topology defines a particular function.

The remarks made hereinbefore demonstrate that the detailed description with reference to the drawings is an illustration of the invention rather than a limitation. The invention can be implemented in numerous alternative ways that are within the scope of the appended claims. All changes that come within the meaning and range of equivalency of the claims are to be embraced within their scope. Any reference sign in a claim should not be construed as limiting the claim. The word "comprising" does not exclude the presence of other elements or steps than those listed in a claim. The word "a" or "an" preceding an element or step S does not exclude the presence of a plurality of such elements or steps. The mere fact that respective dependent claims define respective additional features, does not exclude combinations of additional features other than those reflected in the claims.

## Claims

1. A system (SYS) for measuring an electromagnetic field (EM) comprising:
- an antenna arrangement (AN) comprising an antenna substrate (AB1-AB8) provided with respective antenna devices (AD) at various respective locations on the antenna substrate, an antenna device producing a signal (AS) representative of the electromagnetic field at its location on the antenna substrate;
- a measurement arrangement (MS) adapted to measure a phase difference (MP) between two respective signals from two respective antenna devices at two respective locations on the antenna substrate, and adapted to measure an amplitude (AM) of a signal from an antenna device; and
- a controller (CT) adapted to select at least one signal from at least one antenna device on the antenna substrate to constitute a phase reference signal, on the basis of at least one of the following criteria: the location of the antenna device and the amplitude of the signal provided by the antenna device,
- the controller (CT) being further adapted to subsequently cause the measurement arrangement to measure respective phase differences (MP) between, on the one hand, respective signals from various respective antenna devices at various respective locations on the antenna substrate and, on the other hand, the at least one signal from the at least one antenna device that has been selected to constitute the phase reference signal.

2. A system according to claim 1, in which the controller (CT) is adapted to select as the phase reference signal a signal having the highest amplitude (MA) among the respective signals (AS) provided by the respective antenna devices (AD).

3. A system according to claim 1, in which the controller (CT) is adapted to select as the phase reference signal a signal produced by an antenna device (AD) at a substantially central location on the antenna substrate (AB1-AB8).

4. A system according to any of the preceding claims, in which the controller (CT) is adapted to select as the phase reference signal a combination of various signals from various antenna devices (AD) at various neighboring locations on the antenna substrate (AB1-AB8).

5. A system according to any of the preceding claims, in which the measurement arrangement (MS) is adapted to discard a phase difference (MP) between, on the one hand, a signal from an antenna device (AD) at a location on the antenna substrate (AB 1-AB8) and, on the other hand, the phase reference signal, in case the signal from the antenna device (AD) concerned has an amplitude (MA) that is below a threshold level.

6. A system according to any of the preceding claims, in which the antenna arrangement (AN) comprises a signal transmission substrate (ST1-ST8) orthogonally arranged with respect to the antenna substrate (AB1-AB8), the signal transmission substrate comprising a plurality of transmission lines for transmitting an array of signals produced by an array of antenna devices (AD) towards the measurement arrangement (MS).

7. A system according to any of the preceding claims, in which the measurement arrangement (MS) comprises:
- a selection module (SEL) adapted to select a signal among the respective signals (AS) provided by the antenna arrangement (AN);
- a pair of signal processing paths (SP1, SP2), one of which is adapted to provide a measurement input signal (MI1) in response to the signal selected by the selection module, the other signal processing path being adapted to provide another measurement input signal (MI2) in response to the phase reference signal; and
- a phase measurement module (PM) adapted to measure a phase difference (MP) between the one and the other measurement input signal.

8. A system according to claim 7, in which:
- the pair of signal processing paths (SP1, SP2) are adapted to provide the one and the other measurement input signal (MI1, MI2) as quadrature signals having a pair of components that are orthogonal to each other; and
- the phase measurement module (PM) is adapted to measure an instantaneous phase (IP1) from the pair of components of the measurement input signal, to measure another instantaneous phase (IP2) from the pair of components of the other measurement input signal, and to determine the phase difference (MP) on the basis of a difference between the one and the other instantaneous phase.

9. A system according to claim 8, in which:
- the phase measurement module (PM) is adapted to measure the phase difference (MP) on the basis of a time series of differences between the one and the other instantaneous phase detected at a series of instants.

10. A system according to claim 7, in which the phase measurement module (PM) comprises:
- a pair of Fourier transform modules (FT1, FT2) of which one is adapted to provide a spectral representation of the measurement input signal, the other Fourier transform module being adapted to provide a spectral representation of the other measurement input signal; and
- a spectral phase comparison module (SPC) adapted to determine the phase difference (MP) between the one and the other phase measurement input signal on the basis of the two spectral representations respectively provided by the one and the other Fourier transform module.

11. A system according to claim 10, in which the phase measurement module (PM) comprises:
- a spectral analysis module (SAN) adapted to identify in the spectral representation of the measurement input signal, a frequency band where amplitudes are relatively high,
- the spectral phase comparison module being adapted to determine the phase difference (MP) between one and the other phase measurement input signal by comparing two phase indications in the aforementioned frequency band, one phase indication being present in the spectral representation of the measurement input signal, the other phase indication being present in the spectral representation of the other measurement input signal.

12. A system according to any of the preceding claims, comprising an electromagnetic field reconstitution module (DP) being adapted to establish a three-dimensional representation of the electromagnetic field (EM) on the basis of the electromagnetic field measured in amplitude and phase on the antenna substrate (AB1-AB8).

13. A method of measuring an electromagnetic field (EM), which involves:
- an antenna arrangement (AN) comprising an antenna substrate (AB1-AB8) provided with respective antenna devices (AD) at various respective locations on the antenna substrate,an antenna device producing a signal (AS) representative of the electromagnetic field at its location on the antenna substrate; and
- a measurement arrangement (MS) adapted to measure a phase difference (MP) between two respective signals from two respective antenna devices at two respective locations on the antenna substrate, and adapted to measure an amplitude (AM) of a signal from an antenna device,
the method comprising:
- a phase reference definition step (PHREF) in which a controller (CT) selects at least one signal from at least one antenna device on the antenna substrate to constitute a phase reference signal, on the basis of at least one of the following criteria: the location of the antenna device and the amplitude of the signal provided by the antenna device; and
- a measurement step (MEAS) in which the controller (CT) causes the measurement arrangement to measure respective phase differences (MP) between, on the one hand, respective signals from various respective antenna devices at various respective locations on the antenna substrate and, on the other hand, the at least one signal from the at least one antenna device that has been selected to constitute the phase reference signal.

14. A computer program comprising of a set of instructions that enable a device, which is capable of executing the set of instructions, to carry out the method according to claim 13.

## Patentansprüche

1. System (SYS) zum Messen eines elektromagnetischen Feldes (EM), umfassend:
- eine Antennenanordnung (AN), die ein Antennensubstrat (AB1-AB8) umfasst, welches mit jeweiligen Antennenvorrichtungen (AD) an verschiedenen jeweiligen Stellen auf dem Antennensubstrat versehen ist, wobei eine Antennenvorrichtung ein Signal (AS) erzeugt, das für das elektromagnetische Feld an seiner Stelle auf dem Antennensubstrat repräsentativ ist;
- eine Messanordnung (MS), die dazu ausgebildet ist, eine Phasendifferenz (MP) zwischen zwei jeweiligen Signalen von zwei jeweiligen Antennenvorrichtungen an zwei jeweiligen Stellen auf dem Antennensubstrat zu messen, und dazu ausgebildet ist, eine Amplitude (AM) eines Signals von einer Antennenvorrichtung zu messen; und
- eine Steuerung (CT), die dazu ausgebildet ist, mindestens ein Signal von mindestens einer Antennenvorrichtung auf dem Antennensubstrat, das ein Phasenreferenzsignal darstellen soll, auf der Basis von mindestens einem der folgenden Kriterien auszuwählen: der Stelle der Antennenvorrichtung und der Amplitude des von der Antennenvorrichtung bereitgestellten Signals,
- wobei die Steuerung (CT) weiter dazu ausgebildet ist, die Messanordnung anschließend dazu zu veranlassen, jeweilige Phasendifferenzen (MP) zwischen einerseits jeweiligen Signalen von verschiedenen jeweiligen Antennenvorrichtungen an verschiedenen jeweiligen Stellen auf dem Antennensubstrat, und andererseits dem mindestens einen Signal von der mindestens einen Antennenvorrichtung, das dazu ausgewählt wurde, das Phasenreferenzsignal darzustellen, zu messen.

2. System nach Anspruch 1, wobei die Steuerung (CT) dazu ausgebildet ist, als das Phasenreferenzsignal ein Signal auszuwählen, welches unter den jeweiligen Signalen (AS), die von den jeweiligen Antennenvorrichtungen (AD) bereitgestellt werden, die höchste Amplitude (MA) aufweist.

3. System nach Anspruch 1, wobei die Steuerung (CT) dazu ausgebildet ist, als das Phasenreferenzsignal ein Signal auszuwählen, welches von einer Antennenvorrichtung (AD) an einer im Wesentlichen zentralen Stelle auf dem Antennensubstrat (AB1-AB8) erzeugt wird.

4. System nach einem der vorstehenden Ansprüche, wobei die Steuerung (CT) dazu ausgebildet ist, als das Phasenreferenzsignal eine Kombination aus verschiedenen Signalen von verschiedenen Antennenvorrichtungen (AD) an verschiedenen benachbarten Stellen auf dem Antennensubstrat (AB1-AB8) auszuwählen.

5. System nach einem der vorstehenden Ansprüche, wobei die Messanordnung (MS) dazu ausgebildet ist, eine Phasendifferenz (MP) zwischen einerseits einem Signal von einer Antennenvorrichtung (AD) an einer Stelle auf dem Antennensubstrat (AB1-AB8), und andererseits dem Phasenreferenzsignal zu verwerfen, falls das Signal von der betreffenden Antennenvorrichtung (AD) eine Amplitude (MA) aufweist, die unter einem Schwellenwertpegel liegt.

6. System nach einem der vorstehenden Ansprüche, wobei die Antennenanordnung (AN) ein Signalübertragungssubstrat (ST1-ST8) umfasst, das in Bezug auf das Antennensubstrat (AB1-AB8) orthogonal angeordnet ist, wobei das Signalübertragungssubstrat eine Vielzahl von Übertragungsleitungen umfasst, um eine Reihe von Signalen, die von einer Reihe von Antennenvorrichtungen (AD) erzeugt werden, zur Messanordnung (MS) hin zu übertragen.

7. System nach einem der vorstehenden Ansprüche, wobei die Messanordnung (MS) umfasst:
- ein Auswahlmodul (SEL), das dazu ausgebildet ist, unter den jeweiligen Signalen (AS), die von der Antennenanordnung (AN) bereitgestellt werden, ein Signal auszuwählen;
- ein Paar Signalverarbeitungspfade (SP1, SP2), von denen einer dazu ausgebildet ist, in Reaktion auf das vom Auswahlmodul ausgewählte Signal ein Messeingangssignal (MI1) bereitzustellen, wobei der andere Signalverarbeitungspfad dazu ausgebildet ist, in Reaktion auf das Phasenreferenzsignal ein anderes Messeingangssignal (MI2) bereitzustellen; und
- ein Phasenmessmodul (PM), das dazu ausgebildet ist, eine Phasendifferenz (MP) zwischen dem einen und dem anderen Messeingangssignal zu messen.

8. System nach Anspruch 7, wobei:
- das Signalverarbeitungspfade-Paar (SP1, SP2) dazu ausgebildet ist, das eine und das andere Messeingangssignal (MI1, MI2) als Quadratursignale bereitstellen, die ein Komponentenpaar aufweisen, das zueinander orthogonal ist; und
- das Phasenmessmodul (PM) dazu ausgebildet ist, eine Momentanphase (IP1) vom Komponentenpaar des Messeingangssignals zu messen, eine andere Momentanphase (IP2) vom Komponentenpaar des anderen Messeingangssignals zu messen, und die Phasendifferenz (MP) auf der Basis einer Differenz zwischen der einen und der anderen Momentanphase zu bestimmen.

9. System nach Anspruch 8, wobei:
- das Phasenmessmodul (PM) dazu ausgebildet ist, die Phasendifferenz (MP) auf der Basis einer Zeitserie von Differenzen zwischen der einen und der anderen Momentanphase zu messen, die zu einer Serie von Zeitpunkten erkannt wurden.

10. System nach Anspruch 7, wobei das Phasenmessmodul (PM) umfasst:
- ein Paar Fouriertransformationsmodule (FT1, FT2), von denen eines dazu ausgebildet ist, eine spektrale Darstellung des Messeingangssignals bereitzustellen, wobei das andere Fouriertransformationsmodul dazu ausgebildet ist, eine spektrale Darstellung des anderen Messeingangssignals bereitzustellen; und
- ein Spektralphasen-Vergleichsmodul (SPC), das dazu ausgebildet ist, die Phasendifferenz (MP) zwischen dem einen und dem anderen Phasenmesseingangssignal auf der Basis der zwei spektralen Darstellungen, die jeweils von dem einen und dem anderen Fouriertransformationsmodul bereitgestellt werden, zu bestimmen.

11. System nach Anspruch 10, wobei das Phasenmessmodul (PM) umfasst:
- ein Spektralanalysemodul (SAN), das dazu ausgebildet ist, in der spektralen Darstellung des Messeingangssignals ein Frequenzband zu identifizieren, in dem Amplituden relativ hoch sind,
- wobei das Spektralphasen-Vergleichsmodul dazu ausgebildet ist, die Phasendifferenz (MP) zwischen einem und dem anderen Phasenmesseingangssignal durch Vergleichen von zwei Phasenanzeigen in dem vorstehend genannten Frequenzband zu bestimmen, wobei eine Phasenanzeige in der spektralen Darstellung des Messeingangssignals vorliegt, wobei die andere Phasenanzeige in der spektralen Darstellung des anderen Messeingangssignals vorliegt.

12. System nach einem der vorstehenden Ansprüche, das ein Elektromagnetfeld-Rekonstruktionsmodul (DP) umfasst, welches dazu ausgebildet ist, eine dreidimensionale Darstellung des elektromagnetischen Feldes (EM) auf der Basis des in Amplitude und Phase auf dem Antennensubstrat (AB1-AB8) gemessenen elektromagnetischen Feldes aufzubauen.

13. Verfahren zum Messen eines elektromagnetischen Feldes (EM), welches beinhaltet:
- eine Antennenanordnung (AN), die ein Antennensubstrat (AB1-AB8) umfasst, welches mit jeweiligen Antennenvorrichtungen (AD) an verschiedenen jeweiligen Stellen auf dem Antennensubstrat versehen ist, wobei eine Antennenvorrichtung ein Signal (AS) erzeugt, das für das elektromagnetische Feld an seiner Stelle auf dem Antennensubstrat repräsentativ ist; und
- eine Messanordnung (MS), die dazu ausgebildet ist, eine Phasendifferenz (MP) zwischen zwei jeweiligen Signalen von zwei jeweiligen Antennenvorrichtungen an zwei jeweiligen Stellen auf dem Antennensubstrat zu messen, und dazu ausgebildet ist, eine Amplitude (AM) eines Signals von einer Antennenvorrichtung zu messen,
wobei das Verfahren umfasst:
- einen Phasenreferenz-Definitionsschritt (PHREF), in dem eine Steuerung (CT) mindestens ein Signal von mindestens einer Antennenvorrichtung auf dem Antennensubstrat, das ein Phasenreferenzsignal darstellen soll, auf der Basis von mindestens einem der folgenden Kriterien auswählt: der Stelle der Antennenvorrichtung und der Amplitude des von der Antennenvorrichtung bereitgestellten Signals; und
- einen Messschritt (MEAS), in dem die Steuerung (CT) die Messanordnung dazu veranlasst, jeweilige Phasendifferenzen (MP) zwischen einerseits jeweiligen Signalen von verschiedenen jeweiligen Antennenvorrichtungen an verschiedenen jeweiligen Stellen auf dem Antennensubstrat, und andererseits dem mindestens einen Signal von der mindestens einen Antennenvorrichtung, das dazu ausgewählt wurde, das Phasenreferenzsignal darzustellen, zu messen.

14. Computerprogramm, umfassend einen Satz von Anweisungen, die es einer Vorrichtung, welche in der Lage ist, den Anweisungssatz auszuführen, ermöglichen, das Verfahren nach Anspruch 13 auszuführen.

## Revendications

1. Système (SYS) de mesure d'un champ électromagnétique (EM) comprenant :
- un agencement d'antenne (AN) comprenant un substrat d'antenne (AB1-AB8) pourvu de dispositifs d'antenne respectifs (AD) à divers emplacements respectifs sur le substrat d'antenne, un dispositif d'antenne produisant un signal (AS) représentatif du champ électromagnétique à son emplacement sur le substrat d'antenne ;
- un agencement de mesure (MS) adapté pour mesurer une différence de phase (MP) entre deux signaux respectifs de deux dispositifs d'antenne respectifs à deux emplacements respectifs sur le substrat d'antenne, et adapté pour mesurer une amplitude (AM) d'un signal d'un dispositif d'antenne ; et
- une unité de commande (CT) adaptée pour sélectionner au moins un signal d'au moins un dispositif d'antenne sur le substrat d'antenne pour constituer un signal de référence de phase, sur la base d'au moins l'un des critères suivants : l'emplacement du dispositif d'antenne et l'amplitude du signal fourni par le dispositif d'antenne,
- l'unité de commande (CT) étant en outre adaptée pour amener par la suite l'agencement de mesure à mesurer des différences de phase respectives (MP) entre, d'une part, des signaux respectifs de divers dispositifs d'antenne respectifs en divers emplacements respectifs sur le substrat d'antenne et, d'autre part, le au moins un signal du au moins un dispositif d'antenne qui a été sélectionné pour constituer le signal de référence de phase.

2. Système selon la revendication 1, dans lequel l'unité de commande (CT) est adaptée pour sélectionner comme signal de référence de phase un signal ayant la plus haute amplitude (MA) parmi les signaux respectifs (AS) fournis par les dispositifs d'antenne respectifs (AD).

3. Système selon la revendication 1, dans lequel l'unité de commande (CT) est adaptée pour sélectionner comme signal de référence de phase un signal produit par un dispositif d'antenne (AD) en un emplacement sensiblement central sur le substrat d'antenne (AB1-AB8).

4. Système selon l'une quelconque des revendications précédentes, dans lequel l'unité de commande (CT) est adaptée pour sélectionner comme signal de référence de phase une combinaison de divers signaux de divers dispositifs d'antenne (AD) en divers emplacements voisins sur le substrat d'antenne (AB1-AB8).

5. Système selon l'une quelconque des revendications précédentes, dans lequel l'agencement de mesure (MS) est adapté pour rejeter une différence de phase (MP) entre, d'une part, un signal d'un dispositif d'antenne (AD) en un emplacement sur le substrat d'antenne (AB1-AB8) et, d'autre part, le signal de référence de phase, dans le cas où le signal du dispositif d'antenne (AD) concerné a une amplitude (MA) qui est en dessous d'un niveau de seuil.

6. Système selon l'une quelconque des revendications précédentes, dans lequel l'agencement d'antenne (AN) comprend un substrat de transmission de signal (ST1-ST8) agencé orthogonalement par rapport au substrat d'antenne (AB1-AB8), le substrat de transmission de signal comprenant une pluralité de lignes de transmission destinées à transmettre un jeu de signaux produits par un jeu de dispositifs d'antenne (AD) vers l'agencement de mesure (MS).

7. Système selon l'une quelconque des revendications précédentes, dans lequel l'agencement de mesure (MS) comprend :
- un module de sélection (SEL) adapté pour sélectionner un signal parmi les signaux respectifs (AS) fournis par l'agencement d'antenne (AN) ;
- une paire de chemins de traitement de signal (SP1, SP2), dont l'un est adapté pour fournir un signal d'entrée de mesure (MI1) en réponse au signal sélectionné par le module de sélection, l'autre chemin de traitement de signal étant adapté pour fournir un autre signal d'entrée de mesure (MI2) en réponse au signal de référence de phase ; et
- un module de mesure de phase (PM) adapté pour mesurer une différence de phase (MP) entre l'un et l'autre des signaux d'entrée de mesure.

8. Système selon la revendication 7, dans lequel :
- la paire de chemins de traitement de signal (SP1, SP2) est adaptée pour fournir l'un et l'autre signal d'entrée de mesure (MI1, MI2) comme des signaux en quadrature ayant une paire de composantes qui sont orthogonales les unes aux autres ; et
- le module de mesure de phase (PM) est adapté pour mesurer une phase instantanée (IP1) à partir de la paire de composantes du signal d'entrée de mesure, pour mesurer une autre phase instantanée (IP2) à partir de la paire de composantes de l'autre signal d'entrée de mesure, et pour déterminer la différence de phase (MP) sur la base d'une différence entre l'une et l'autre phase instantanée.

9. Système selon la revendication 8, dans lequel :
- le module de mesure de phase (PM) est adapté pour mesurer la différence de phase (MP) sur la base d'une série chronologique de différences entre l'une et l'autre phase instantanée détectée à une série d'instants.

10. Système selon la revendication 7, dans lequel le module de mesure de phase (PM) comprend :
- une paire de modules de transformée de Fourier (FT1, FT2) dont l'un est adapté pour fournir une représentation spectrale du signal d'entrée de mesure, l'autre module de transformée de Fourier étant adapté pour fournir une représentation spectrale de l'autre signal d'entrée de mesure ; et
- un module de comparaison de phase spectrale (SPC) adapté pour déterminer la différence de phase (MP) entre l'un et l'autre signal d'entrée de mesure de phase sur la base des deux représentations spectrales respectivement fournies par l'un et l'autre module de transformée de Fourier.

11. Système selon la revendication 10, dans lequel le module de mesure de phase (PM) comprend :
- un module d'analyse spectrale (SAN) adapté pour identifier dans la représentation spectrale du signal d'entrée de mesure, une bande de fréquence où des amplitudes sont relativement hautes,
- le module de comparaison de phase spectrale étant adapté pour déterminer la différence de phase (MP) entre l'un et l'autre signal d'entrée de mesure de phase en comparant deux indications de phase dans la bande de fréquence précitée, une indication de phase étant présente dans la représentation spectrale du signal d'entrée de mesure, l'autre indication de phase étant présente dans la représentation spectrale de l'autre signal d'entrée de mesure.

12. Système selon l'une quelconque des revendications précédentes, comprenant un module de reconstitution de champ électromagnétique (DP) qui est adapté pour établir une représentation tridimensionnelle du champ électromagnétique (EM) sur la base du champ électromagnétique mesuré en amplitude et en phase sur le substrat d'antenne (AB1-AB8).

13. Procédé de mesure d'un champ électromagnétique (EM), qui implique :
- un agencement d'antenne (AN) comprenant un substrat d'antenne (AB1-AB8) pourvu de dispositifs d'antenne respectifs (AD) à divers emplacements respectifs sur le substrat d'antenne, un dispositif d'antenne produisant un signal (AS) représentatif du champ électromagnétique à son emplacement sur le substrat d'antenne ; et
- un agencement de mesure (MS) adapté pour mesurer une différence de phase (MP) entre deux signaux respectifs de deux dispositifs d'antenne respectifs en deux emplacements respectifs sur le substrat d'antenne, et adapté pour mesurer une amplitude (AM) d'un signal d'un dispositif d'antenne,
le procédé comprenant :
- une étape de définition de référence de phase (PHREF) dans laquelle une unité de commande (CT) sélectionne au moins un signal d'au moins un dispositif d'antenne sur le substrat d'antenne pour constituer un signal de référence de phase, sur la base d'au moins l'un des critères suivants : l'emplacement du dispositif d'antenne et l'amplitude du signal fourni par le dispositif d'antenne, et
- une étape de mesure (MEAS) dans laquelle l'unité de commande (CT) amène l'agencement de mesure à mesurer des différences de phase respectives (MP) entre, d'une part, des signaux respectifs de divers dispositifs d'antenne respectifs en divers emplacements respectifs sur le substrat d'antenne et, d'autre part, le au moins un signal du au moins un dispositif d'antenne qui a été sélectionné pour constituer le signal de référence de phase.

14. Programme d'ordinateur comprenant au moins un jeu d'instructions qui permettent à un dispositif, qui est capable d'exécuter le jeu d'instructions, de réaliser le procédé selon la revendication 13.
